# EUROPEAN PATENT APPLICATION

(11) **EP 4 474 220 A1**
(43) Date of publication of application: **11.12.2024**
(21) Application number: 24178737.3
(22) Date of filing: 29.05.2024
(51) Int. Cl.: B60R 1/26, H01L 25/075

(54) **DISPLAY DEVICE**

(30) Priority: 07.06.2023 JP 2023093983
(71) Applicant: Alps Alpine Co., Ltd., Ota-ku, Tokyo 145-8501 (JP)
(72) Inventor: Kishida, Katsuhiko, Iwaki-City (JP)
(74) Representative: Schmitt-Nilson Schraud Waibel Wohlfrom Patentanwälte Partnerschaft mbB

(57) **Abstract**

A display device includes a first substrate and a second substrate. The first substrate is a passive drive substrate. The first substrate includes a plurality of first light emitters arranged two dimensionally. The first light emitters are arranged at respective intersections of a plurality of data lines and a plurality of scan lines. The second substrate is a passive drive light transmissive substrate. The second substrate includes a plurality of second light emitters arranged two dimensionally. The second light emitters are arranged at respective intersections of the plurality of data lines and the plurality of scan lines. The second substrate is stacked over the first substrate, such that the second light emitters are provided at respective positions not overlapping with the first light emitters.

## Description

The present disclosure relates to a display device including a plurality of light emitters formed on a substrate, and particularly to a display device having a passive drive micro light emitting diode (LED).

In recent years, a micro LED capable of directly displaying an image from a light emitting diode has been developed. The micro LEDs are arranged two dimensionally to correspond to each pixel, and each pixel is configured to include blue, green, and red subpixels. When the subpixels are arranged on a two dimensional plane, the area occupied by each subpixel is increased. On the other hand, arranging the subpixels in a limited area requires a reduction in the area of each subpixel, which results in a reduction in the brightness of the subpixels.

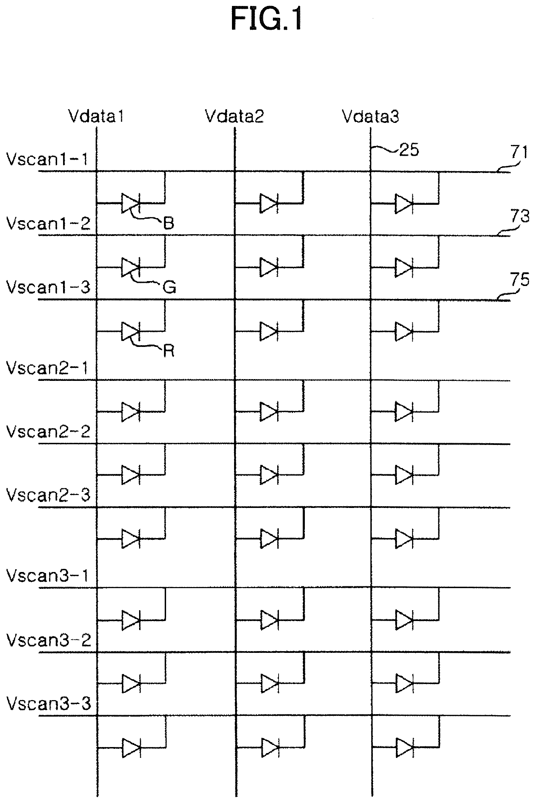

The LED stack for a display disclosed in Patent Document 1 (see JP2021-504752A) is configured such that a first LED stack, a second LED stack, and a third LED stack are vertically stacked, the first LED stack corresponds to a red light emitting diode R, the second LED stack corresponds to a green light emitting diode G, and the third LED stack corresponds to a blue light emitting diode B, and the light emitting diodes R, G, and B correspond to subpixels. FIG. 1 is a passive drive circuit diagram illustrating an LED stack for a display. Anodes of the first to third light emitting diodes R, G, and B are connected in common to the data line Vdata1, cathodes thereof are connected to the scan lines Vscan1-1, Vscan1-2, and Vscan1-3, respectively, and the light emitting diodes R, G, and B in the same pixel are driven independently of each other.

As illustrated in FIG. 2, the active drive micro LED disclosed in Patent Document 2 (see U.S. Pat. No. 11,171,270) has a structure in which a semiconducting layer 120 is formed on a substrate 100 via a buffer layer 110, a thin film transistor (TFT) including a gate electrode 140, a drain electrode 160a, and a source electrode 160b is formed on the semiconducting layer 120, a first electrode 190 connected to the source electrode 160b via a planarization layer 170 is formed, and a LED 200 including a p-n diode 250 is formed between the first electrode 190 and a second electrode 260.

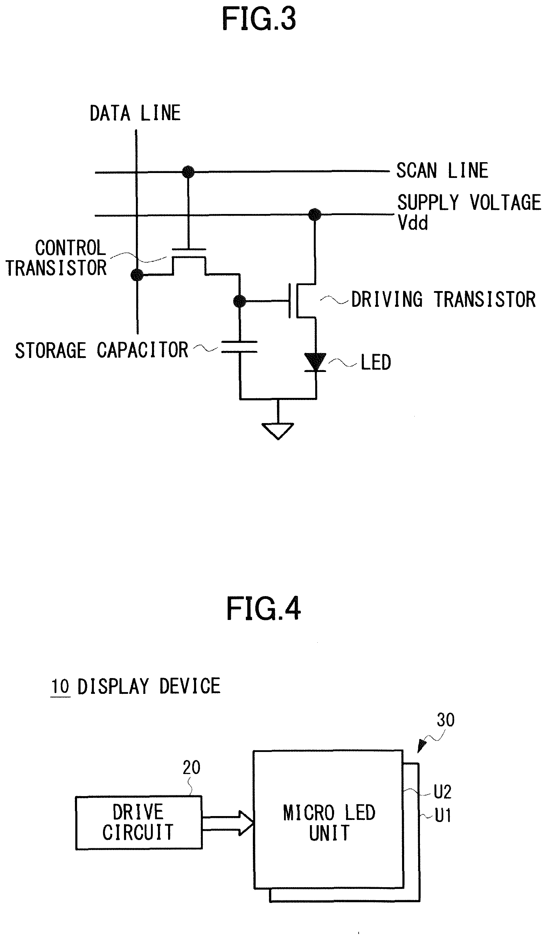

FIG. 3 is an active drive circuit diagram. As illustrated in the drawing, the micro LED and the driving transistor are connected in series between a supply voltage Vdd and grounding GND, the control transistor and the storage capacitor are connected in series between the data line and GND, the gate of the control transistor is connected to the scan line, and the connection node of the control transistor and the storage capacitor is connected to the gate of the driving transistor. When the control transistor is turned on by the scan line, a data signal from the data line is applied to the gate of the driving transistor, and the LED emits light by a drive current corresponding to the data signal.

The present disclosure relates to a display device according to the appended claims. Embodiments are disclosed in the dependent claims.

According to an embodiment of the present disclosure, a display device includes
a first substrate; and
a second substrate,
wherein the first substrate is a passive drive substrate, the first substrate including a plurality of first light emitters arranged two dimensionally, the first light emitters being arranged at respective intersections of a plurality of data lines and a plurality of scan lines,
wherein the second substrate is a passive drive light transmissive substrate, the second substrate including a plurality of second light emitters arranged two dimensionally, the second light emitters being arranged at respective intersections of the plurality of data lines and the plurality of scan lines, and
wherein the second substrate is stacked over the first substrate, such that the second light emitters are provided at respective positions not overlapping with the first light emitters.

According to an embodiment, the first light emitters are arranged at a constant pitch in an X direction and a Y direction, and the second light emitters are arranged to be shifted by 1/2 a value of the constant pitch in the X direction and the Y direction with respect to the first light emitters. Particularly, X and Y direction are perpendicular to each other, e.g. axes of a two-dimensional coordinate system.

According to an embodiment, a transparent protective material is provided between the first substrate and the second substrate, and light emitted from the first light emitters is emitted from a surface of the second substrate through the transparent protective material.

According to an embodiment, a refractive index of the second substrate is greater than a refractive index of the transparent protective material, and light emitted from the first light emitter is refracted toward a normal due to a difference in a refractive index between the transparent protective material and the second substrate.

According to an embodiment, recesses are formed on a back surface of the second substrate at respective positions corresponding to the plurality of first light emitters, and the first light emitters are accommodated in the recesses, respectively.

According to an embodiment, the second substrate is a transparent film substrate, and the transparent film substrate is deformed to conform to respective surface shapes of the first light emitters on the first substrate.

According to an embodiment, the first and second light emitters each correspond to a pixel, the first and second light emitters each include elements that emit R, G, and B light, and the elements that emit R, G, and B light correspond to subpixels.

Other objects and further features of the present invention will be apparent from the following detailed description when read in conjunction with the accompanying drawings, in which:
FIG. 1 is a diagram illustrating a passive drive circuit configuration;

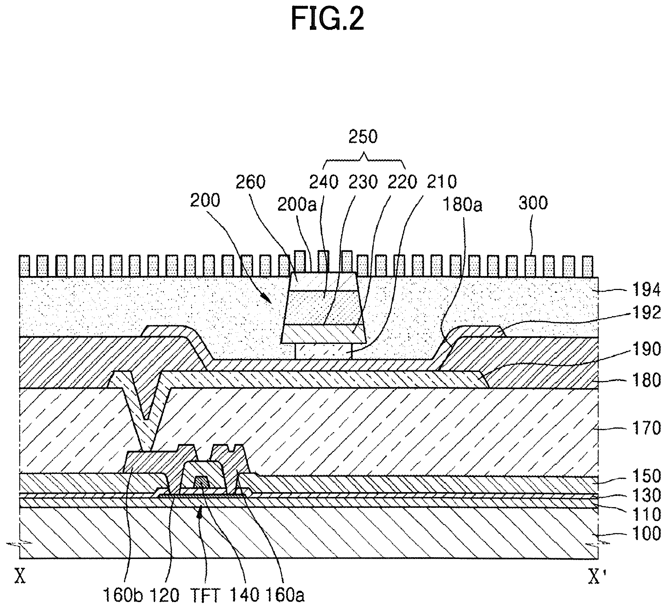

FIG. 2 is a diagram illustrating a cross-sectional configuration of a related-art active drive micro LED;
FIG. 3 is a diagram illustrating an active drive circuit configuration;
FIG. 4 is a block diagram illustrating a configuration of a display device according to an embodiment of the present disclosure;
FIG. 5 is a passive drive wiring diagram according to an embodiment of the present disclosure;
FIG. 6A is a schematic cross-sectional diagram illustrating a micro LED unit according to a first embodiment of the present disclosure, and FIG. 6B is a planar perspective diagram illustrating a position of a micro LED when micro LED units are stacked;
FIGS. 7A and 7B are schematic sectional diagrams illustrating a micro LED unit according to a second embodiment of the present disclosure;
FIGS. 8A and 8B are schematic sectional diagrams illustrating a micro LED unit according to a third embodiment of the present disclosure; and
FIGS. 9A to 9B are schematic cross-sectional diagrams illustrating a micro LED unit according to a fourth embodiment of the present disclosure.

In a transparent display using the micro LEDs, active drive is used to display a high-definition image. However, the active drive is not suitable for small-lot production because the initial cost of masks or the like is high because switching elements such as TFTs are formed in pixels of a substrate. The passive drive has advantages in that the number of masks is small and initial cost is low because TFTs and the like are not formed, and pixels (LEDs) are turned on only at the moment when a line is scanned in one frame because of a time-division driving method, and therefore, when the number of pixels increases, the energization time of the pixels per unit time is shortened and luminance is lowered.

Thus, it is desirable to provide a display device capable of displaying a high-definition and high-luminance image even in a passive drive mode.

According to at least one aspect of the embodiment of the present disclosure, since the second substrate on which the second light emitters are arranged at respective positions not overlapping the first light emitters is stacked on the first substrate on which the first light emitters are formed, it is possible to prevent a luminance from being lowered due to the reduction of the energization time of the light emitter, and thus it is possible to obtain a high-definition display.

The present disclosure relates to a display device capable of displaying a high-definition image by driving light emitters (e.g., micro LEDs) by passive driving. Each light emitter is not particularly specified, but is, for example, a micro LED. It should be noted that the drawings referred to in the following description of the embodiments include exaggerated representations for facilitating understanding of the invention, and do not represent the actual shapes and scales of products as they are.

### [Embodiments]

FIG. 4 is a block diagram illustrating a configuration of a display device according to an embodiment of the present disclosure. As illustrated in FIG. 4, a display device 10 of the present embodiment includes a drive circuit 20 and a transparent display 30 driven by the drive circuit 20. The transparent display 30 includes two stacked micro LED units U1 and U2 as described below, and the micro LED units U1 and U2 are independently driven by the drive circuit 20. The display device 10 of the present embodiment implements high-definition and high-luminance display while being passively driven by forming the transparent display 30 from a stack of two micro LED units U1 and U2.

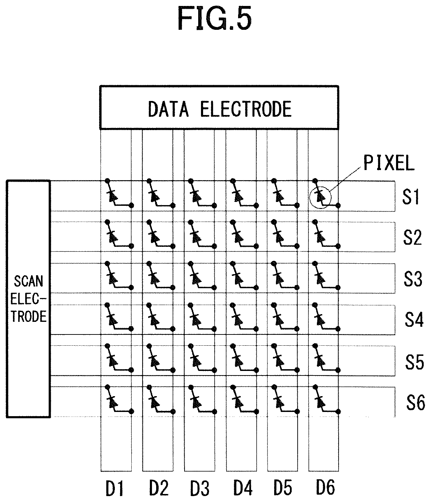

FIG. 5 is a diagram illustrating a passive drive circuit configuration. The micro LED unit U1 and the micro LED unit U2 have the same circuit configuration, and have the passive drive circuit configuration illustrated in FIG. 5.

Each of the micro LED units U1 and U2 includes a plurality of scan-electrode lines S1, S2, ..., S5, S6 extending in a row direction (X direction), a plurality of data-electrode lines D1, D2, ..., D5, D6 extending in a column direction (Y direction), and micro LEDs connected to the intersections of the scan-electrode lines and the data-electrode lines. Although six scan-electrode lines and six data-electrode lines are illustrated for convenience, the number of scan-electrode lines and data-electrode lines formed in practice corresponds to the number of pixels.

The scan-electrode line and the data-electrode line are formed, for example, by using a multilayer wiring structure on the substrate, the scan-electrode line is formed as a lower layer wiring, the data-electrode line is formed as an upper layer wiring, and an insulating layer is formed between the lower layer wiring and the upper layer wiring. The upper and lower wiring layers may be reversed. At the intersection of the scan-electrode line and the data-electrode line, for example, the scan-electrode line is electrically connected to a cathode electrode of the micro LED, and the data-electrode line is electrically connected to an anode electrode.

The drive circuit 20 drives the scan-electrode line in a time-division manner at a constant scan frequency. For example, when the scan-electrode line S1 is driven, a data signal is applied from the data-electrode lines D1, D2, ..., D5, D6 to each of the micro-LEDs at the intersections of the scan-electrode line S1 and the data-electrode lines D1, D2, ..., D5, D6, and the micro-LEDs at these lines are turned on. Subsequently, when the scan-electrode line S2 is driven, a data signal is applied from the data-electrode lines D1, D2, ..., D5, D6 to each of the micro-LEDs at the intersections of the scan-electrode line S2 and the data-electrode lines D1, D2, ..., D5, D6, and the micro-LEDs at these lines are turned on. In this way, the scan-electrode lines are sequentially driven from S1 to S6, thereby displaying one frame.

The drive circuit 20 supplies a drive current to the micro LEDs via the data-electrode lines D1, D2, ..., D5, and D6 in synchronization with the scanning of the scan-electrode lines. The micro LED emits light with a luminance corresponding to the applied data signal.

The drive circuit 20 is connected to each of the micro LED units U1 and U2, and can drive the micro LED units U1 and U2 independently at the same time, or can drive only one selected from the micro LED units U1 and U2.

Although one pixel is illustrated as one LED in FIG. 5, one pixel is composed of three subpixels that generate R (red), G (green), and B (blue) when the transparent display 30 displays a color image. The configurations of the R, G, and B subpixels are not particularly specified, but the R, G, and B subpixels may be configured by a diode emitting red light, a diode emitting green light, and a diode emitting blue light. Alternatively, the R and G light emitters may be formed using fluorescent filters that generate red and green light from the diode emitting blue light. In the case where the R, G, and B subpixels are included, the R, G, and B subpixels are driven by using the scan-electrode lines and the data-electrode lines connected to the R, G, and B subpixels, respectively, in the passive driving, as illustrated in FIG. 1. The micro LED may be, for example, a white diode that generates white light or an infrared diode that generates infrared light.

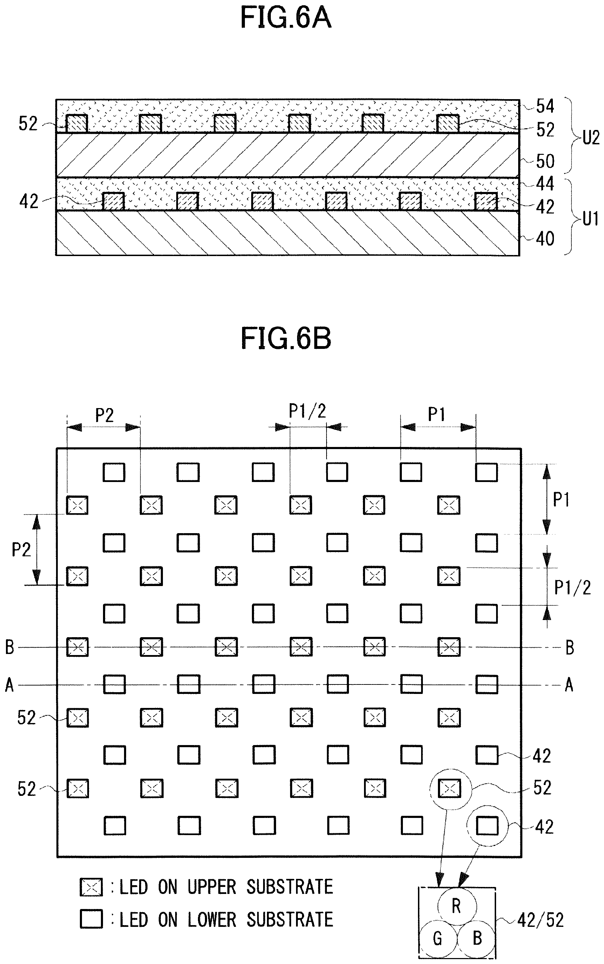

FIGS. 6A and 6B are diagrams illustrating a configuration of the transparent display 30 according to the first embodiment of the present disclosure, where FIG. 6A illustrates a cross section of the micro LED unit U1 taken along line A-A and a cross section of the micro LED unit U2 taken along line B-B, and FIG. 6B is a plan perspective diagram illustrating the positions of the micro LEDs when the micro LED units U1 and U2 are stacked.

As illustrated in FIG. 6A, the micro LED unit U1 includes a passive drive lower substrate 40, a plurality of scan-electrode lines and a plurality of data-electrode lines (not illustrated), a plurality of micro LEDs 42 formed at the intersections of the scan-electrode lines and the data-electrode lines, and a transparent protective material 44 covering the entire substrate including the micro LED 42. The passive drive lower substrate 40 is not particularly specified, but is configured using, for example, a semiconductor substrate such as silicon, a glass substrate, or the like. The transparent protective material 44 is not particularly specified, and is made of a material such as polyethylene terephthalate (PET), polypropylene (PP), or polyvinyl chloride (PVC).

FIG. 6B is a plan diagram illustrating the positions of the micro LEDs when two micro LED units U1 and U2 are stacked, and the micro LEDs 42 are arranged on the substrate 40 in the row direction and the column direction at a pitch P1 as illustrated in the drawing. When one micro LED 42 corresponds to one pixel and the micro LED 42 includes R, G, and B subpixels, the entire micro LED including the R, G, and B subpixels is one pixel, and the pixel pitch is P1.

The micro LED unit U2 is configured to include a passive drive upper substrate 50, a plurality of scan-electrode lines and a plurality of data-electrode lines (not illustrated), a plurality of micro LEDs 52 formed at the intersections of the scan-electrode lines and the data-electrode lines, and a transparent protective material 54 covering the entire surface of the substrate including the micro LEDs 52.

As illustrated in FIG. 6B, the micro LEDs 52 are arranged on the substrate 50 at a pitch P2 in the row direction and the column direction (pitch P2 = pitch P1), and the micro LED unit U2 is configured such that the micro LEDs 42 are shifted from the micro LEDs 52 by 1/2 a value of the constant pitch (P1/2), that is, the micro LEDs 42 and the micro LEDs 52 are arranged in a staggered manner or in an alternate manner when the micro LED unit U2 is stacked over the micro LED unit U1.

The passive drive upper substrate 50 is formed of a light transmissive material, for example, glass or acrylic, in order to transmit light emitted from the micro LED units U1. The passive drive upper substrate 50 is preferably as thin as possible, and is, for example, 0.2 to 0. 3 mm. Thus, when the micro LED unit U2 is stacked over the micro LED unit U1, the height of the micro LED 42 is made close to the height of the micro LED 52, and for both the micro LEDs 42 and the micro LEDs 52, micro LED heights in a same layer are formed so as to be close to each other.

In addition, it is desirable to secure transparency of the stacked micro LED units U1 and U2 by minimizing the difference in the refractive index between the passive drive upper substrate 50 and the transparent protective material 44 of the micro LED unit U1. In this case, for example, the transparent protective material 44 is made of a high-refractive silicone having a refractive index of about 1.53, and the passive drive upper substrate 50 is made of glass having a refractive index of about 1.52.

Further, the scan-electrode lines and the data-electrode lines formed on the passive drive upper substrate 50 may be made of transparent electrodes such as ITO so as not to shield the light incident from the micro LEDs 42.

When displaying one frame, the drive circuit 20 drives the micro LED unit U1 in a time-division manner at the scan frequency F1, and drives the macro LED unit U2 in a time-division manner at the scan frequency F2 (F2 = F1).

The light emitted from the micro LEDs 42 of the micro LED unit U1 is incident on the back surface of the micro LED unit U2. Since the micro LEDs 42 are located at respective positions not overlapping the micro LEDs 52, the light emitted from the micro LEDs 42 passes through the passive drive upper substrate 50 and the transparent protective material 54, and is emitted from the surface of the micro LED unit U2. The light emitted from the micro LEDs 52 is also emitted from the surface of the micro LED unit U2 through the transparent protective material 54. Thus, the transparent display 30 displays a frame image obtained by combining a frame image generated by the micro LED unit U1 and a frame image generated by the micro LED unit U2.

According to the present embodiment, by stacking two micro LED units U1 and U2 so that the positions of the pixels do not overlap, a high-definition image in which the number of pixels is doubled can be displayed in practice. In addition, since the stacked micro LED units U1 and U2 are independently driven, it is possible to prevent the energization time of the pixel per unit time from being shortened, to prevent a decrease in brightness, and to display a high-brightness image.

Next, a second embodiment of the present disclosure will be described. In the stacked structure of the micro LED units U1 and U2 illustrated in a first embodiment, there is a possibility that light emitted from the micro LEDs 42 of the passive drive lower substrate 40 is diffused due to the directivity of the micro LEDs and the diffused light is blocked by the micro LEDs 52 of the passive drive upper substrate 50.

Therefore, in the second embodiment, the refraction index n2 of the passive drive upper substrate 50 of the micro LED unit U2 is made greater than the refraction index n1 (n2 > n1) of the transparent protective material 44 of the micro LED unit U1, and the light emitted from the micro LEDs 42 is focused toward the direction normal to the boundary between the transparent protective material 44 and the passive drive upper substrate 50. In this case, it is desirable to make the thickness of the transparent protective material 44 as thin as possible.

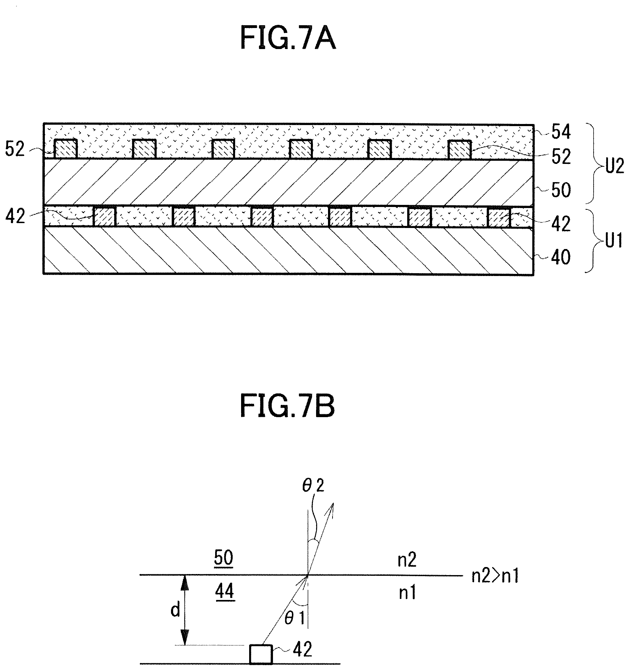

FIGS. 7A and 7B are diagrams illustrating the second embodiment. As illustrated in FIG. 7A, the transparent protective material 44 of the micro LED unit U1 is made of a low-refractive silicone (n1 = 1.41) as a low-refractive material, and is as thin as possible to reduce the diffusion length from the light emitting point of the micro LED 42 by reducing the length d from the micro LED 42 to the passive drive upper substrate 50. Conversely, the passive drive upper substrate 50 is made of a high-refractive index material (n2 = 1.71). As illustrated in FIG. 7B, due to the difference in the refractive index between the transparent protective material 44 and the passive drive upper substrate 50, the light generated from the micro LED 42 is refracted toward the direction normal to the interface (n1 × sin θ1 = n2 × sin θ2), that is, the light is refracted toward the normal.

As described above, according to the second embodiment, by focusing the light emitted from the micro LEDs 42 toward the normal, it is possible to prevent the light incident from the micro LEDs 42 from being blocked by the micro LEDs 52, and thus it is possible to display a high-definition and high-luminance image.

Next, a third embodiment of the present disclosure will be described. In the stacked structure of the micro LED units U1 and U2 illustrated in the first embodiment, it may be necessary to further prevent the light emitted from the micro LEDs 42 from being blocked by the passive drive upper substrate 50.

Hence, in the third embodiment, recesses or depressions are formed on the back surface of the passive drive upper substrate 50 so as to avoid the micro LEDs 42, such that when the micro LED unit U2 is stacked over the micro LED unit U1, the micro LEDs 42 are made closer to the micro LEDs 52.

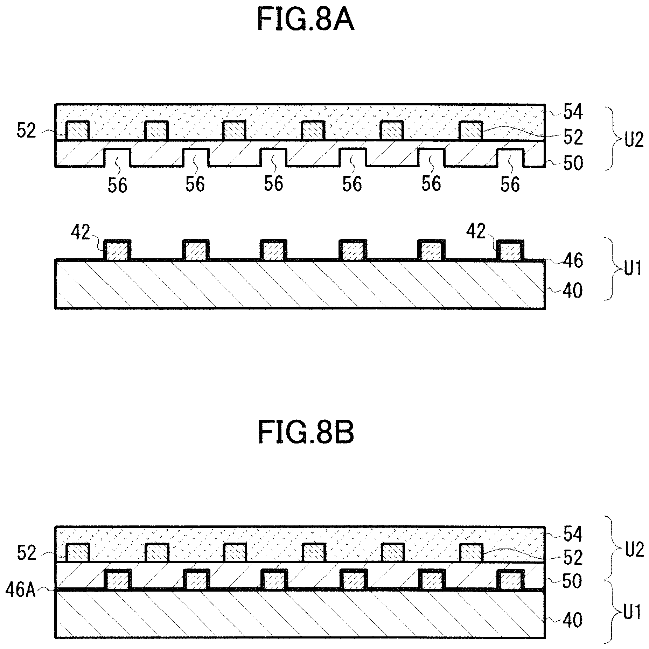

FIGS. 8A and 8B are diagrams illustrating a third embodiment. FIG. 8A illustrates a cross section of each of the micro LED unit U1 and the micro LED unit U2 before being stacked. In the micro LED unit U1, the entire surface of the substrate is covered with a flexible transparent film 46 as a transparent protective material. The transparent film 46 has an outline that follows the unevenness of the surfaces of the micro LEDs 42 and the passive drive lower substrate 40.

In the micro LED unit U2, a plurality of holes or recesses 56 are formed in the back surface of the passive drive upper substrate 50. The recesses 56 are processed in shape or size capable of substantially accommodating the micro LEDs 42 at respective positions corresponding to the micro LEDs 42 of the passive drive lower substrate 40.

FIG. 8B illustrates a cross section when the micro LED unit U2 is stacked over the micro LED unit U1. The micro LEDs 42 of the passive drive lower substrate 40 are accommodated in the recesses 56 of the back surface of the passive drive upper substrate 50 of the micro LED unit U2 via the transparent film 46, and the region of the passive drive lower substrate 40 where the micro LED 42 is not formed is substantially in contact with the back surface of the passive drive upper substrate 50 via the transparent film 46.

According to the third embodiment, the micro LEDs 42 are accommodated in the recesses 56 and the micro LEDs 42 are brought close to the micro LEDs 52, whereby the light emitted from the micro LEDs 42 is prevented from being shielded by the micro LEDs 52, and thus, a high-definition and high-luminance image can be displayed.

Next, a fourth embodiment of the present disclosure will be described. The fourth embodiment is a further improvement of the third embodiment, and a transparent film substrate is used for the upper passive drive substrate, and the micro LEDs of the lower passive drive substrate and the micro LEDs of the upper passive drive substrate are made to have substantially the same height.

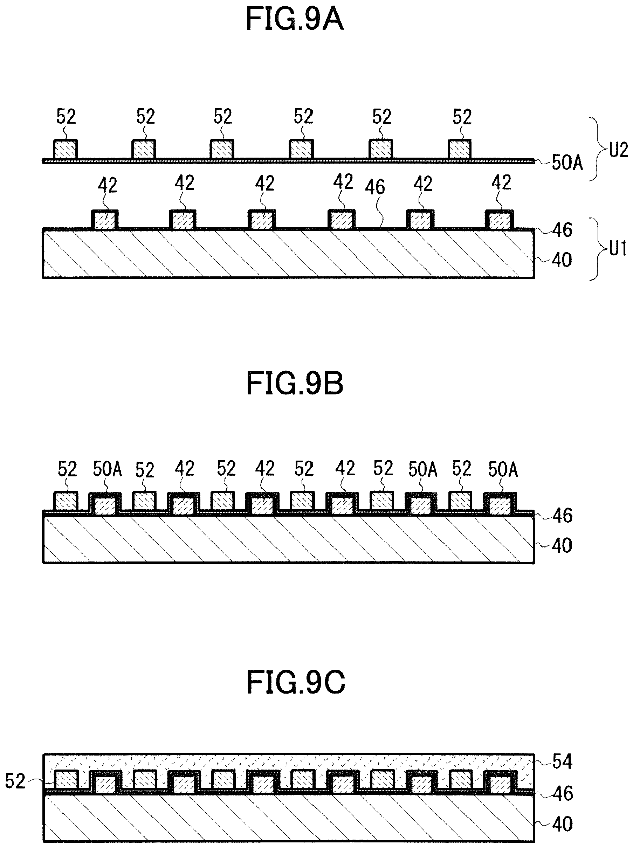

FIGS. 9A to 9C are diagrams illustrating a fourth embodiment. As illustrated in FIG. 9A, the micro LED unit U1 is configured in the same manner as in the third embodiment, and the entire surface of the passive drive lower substrate 40 including the micro LEDs 42 is covered with the transparent film 46. A passive drive upper substrate 50A of the micro LED unit U2 is made of a flexible transparent film substrate, and the micro LEDs 52 are formed on the substrate.

As illustrated in FIG. 9B, when the passive drive upper substrate 50A is stacked over the passive drive lower substrate 40, the passive drive upper substrate 50A is deformed so as to conform to protrusions of the micro LEDs 42 on the passive drive lower substrate 40. Accordingly, the heights of the micro LEDs 42 of the passive drive lower substrate 40 are substantially equal to the heights of the micro LEDs 52 of the passive drive upper substrate LED 50A.

Next, as illustrated in FIG. 9C, a transparent protective material 54 is applied to the entire surface of the substrate including the micro LEDs 42 and the micro LEDs 52. The transparent protective material 54 may be applied to the passive drive upper substrate 50A in advance, or the transparent protective material 54 may be replaced with a transparent film.

According to the fourth embodiment, the passive drive upper substrate 50A is made of a flexible transparent film substrate, and when the passive drive upper substrate 50A is stacked on the passive drive lower substrate 40, the passive drive upper substrate 50A is deformed to make the heights of the micro LEDs 42 substantially equal to the heights of the micro LEDs 52, so that the light emitted from the micro LEDs 42 is prevented from being blocked by the micro LEDs 52, and as a result, high-definition and high-luminance display can be obtained.

In the above embodiment, an example in which two micro LED units are stacked is illustrated, but the present disclosure is not limited thereto, and three or more micro LED units may be stacked. For example, when three micro LED units are stacked, the micro LEDs of the layers are arranged so as to be shifted by 1/3 pitch from each other in the row and column directions. When four micro LED units are stacked, the micro LEDs of the layers are arranged so as to be shifted from each other by 1/4 a value of the constant pitch in the row and column directions.

Although the preferred embodiments of the present disclosure have been described in detail, the present disclosure is not limited to the specific embodiments, and various modifications and alterations may be made within the scope of the claims.

## Claims

1. A display device comprising:
a first substrate; and
a second substrate,
wherein the first substrate is a passive drive substrate, the first substrate including a plurality of first light emitters arranged two dimensionally, and the first light emitters being arranged at respective intersections of a plurality of data lines and a plurality of scan lines,
wherein the second substrate is a passive drive light transmissive substrate, the second substrate including a plurality of second light emitters arranged two dimensionally, and the second light emitters being arranged at respective intersections of the plurality of data lines and the plurality of scan lines, and
wherein the second substrate is stacked over the first substrate, such that the second light emitters are provided at respective positions not overlapping with the first light emitters.

2. The display device according to claim 1, wherein the first light emitters are arranged at a constant pitch in an X direction and a Y direction, and the second light emitters are arranged to be shifted by 1/2 a value of the constant pitch in the X direction and the Y direction with respect to the first light emitters.

3. The display device according to claim 1 or 2, further comprising:
a transparent protective material between the first substrate and the second substrate,
wherein light emitted from the first light emitters is emitted from a surface of the second substrate through the transparent protective material.

4. The display device according to claim 3,
wherein a refractive index of the second substrate is greater than a refractive index of the transparent protective material, and light emitted from the first light emitter is refracted toward a normal due to a difference in a refractive index between the transparent protective material and the second substrate.

5. The display device according to one of claims 1 to 4, wherein recesses are formed on a back surface of the second substrate at respective positions corresponding to the plurality of first light emitters, and the first light emitters are accommodated in the recesses, respectively.

6. The display device according to one of claims 1 to 5, wherein the second substrate is a transparent film substrate, and the transparent film substrate is deformed to conform to respective surface shapes of the first light emitters on the first substrate.

7. The display device according to one of claims 1 to 6, wherein the first and second light emitters each correspond to a pixel, the first and second light emitters each include elements that emit R, G, and B light, and the elements that emit R, G, and B light correspond to subpixels.
